# EUROPEAN PATENT APPLICATION

(11) **EP 2 405 479 A1**
(43) Date of publication of application: **11.01.2012**
(21) Application number: 10748592.2
(22) Date of filing: 04.02.2010
(51) Int. Cl.: H01L 21/82, H05B 37/03

(54) **ANTIFUSE DEVICE**

(30) Priority: 02.03.2009 JP 2009048598
(71) Applicant: Murata Manufacturing Co., Ltd., Kyoto 617-8555 (JP)
(72) Inventor: NAKAISO Toshiyuki, Nagaokakyo-shi Kyoto 617-8555 (JP); TAKESHIMA Yutaka, Nagaokakyo-shi Kyoto 617-8555 (JP)
(74) Representative: Stöckeler, Ferdinand
(86) International application number: PCT/JP2010/051606
(87) International publication number: WO 2010/100995

(57) **Abstract**

First and second electrode films 4 and 6 are formed on both of upper and lower surfaces of a dielectric thin film 5, whereby an element body 9 is formed (a). When an operation voltage is applied to the element body 9, the first and second electrode films 4 and 6 are fused by heat generation by electrification, whereby balled portions 13a, 13b, 14a and 14b are formed, and a crack 15 also occurs in the dielectric thin film 5 (b). Then, the balled portions are enlarged, the dielectric thin film 5 is completely divided (c), and the first and second electrode films 4 and 6 are welded and integrated with each other in a mode of tangling end portions of the dielectric thin film 5, and form bonded portions 16 and 17 to turn to a conducting state (d). In such a way, an anti-fuse element is realized, which stably operates at low resistance after an operation even if being electrified with a large current, and has a function as an ESD countermeasure element before the operation.

## Description

### TECHNICAL FIELD

The present invention relates to an anti-fuse element, and more specifically, to an anti-fuse element, which is connected in parallel to an electronic component or an electronic instrument, is irreversibly changed from high resistance to low resistance by being applied with an overvoltage, and thereby forms a bypass circuit.

### BACKGROUND ART

On liquid crystal display devices and a variety of illumination devices, a large number of light emitting diodes (hereinafter, referred to as "LEDs") are mounted as light emitting sources.

Moreover, on a variety of electronic instruments in recent years, a large number of electronic components such as Zener diodes and varistors are implemented on an electronic circuit board.

Then, in the case where the large number of electronic components as described above are connected in series to one another, compensation elements called anti-fuse elements are connected in parallel to the respective electronic components so that operations of other electronic components cannot be affected even if a specific electronic component is broken to cause an opening failure due to its lifetime and the like. Each of the anti-fuse elements is in an insulating state when each of the electronic components such as the LEDs performs a normal operation. When the electronic component causes the opening failure by the breakage and the like, the anti-fuse element short-circuits itself and turns to a conducting state. In such a way, the anti-fuse element avoids stopping of the operations of the other electronic components.

For example, in Patent Literature 1, a light emitting diode lighting circuit is proposed, which includes: anti-fuse elements (compensation elements), each of which is connected in parallel to each of a plurality of LEDs, and has conductors provided in vicinities of respective terminals on a positive electrode side and a negative electrode side, the conductors having a predetermined melting point. In this light emitting diode lighting circuit, in the case where the opening failure occurs in an LED, both of the terminals of the compensation element connected in parallel to the LED are welded together by the conductors provided in the compensation element.

In Patent Literature 1, as shown in FIG. 16(a), a compensation element 101 includes: an insulator 103 on which a resistor element 102 is overcoated or printed; terminals 104 and 105, which are provided on both sides of the insulator 103, and are connected to a positive electrode side and negative electrode side of the resistor element 102; and low melting point conductors 106 and 107, which are fused at a predetermined temperature, and are formed on respective connection portions between the insulator 103 and the terminals 104 and 105 and on peripheries thereof.

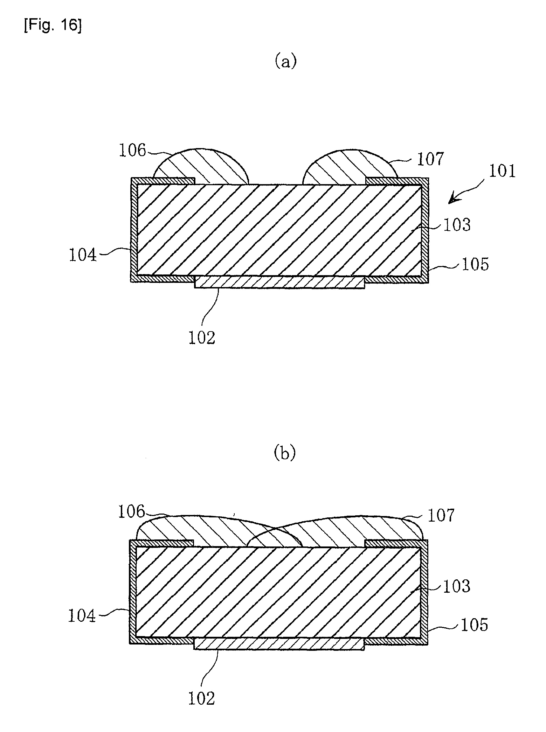

Then, when the LED operates normally, the low melting point conductors 106 and 107 are separated from each other as shown in FIG. 16(a), and maintain an electrically insulating state. Meanwhile, when the LED causes the opening failure by being broken and so on, a current flows through the anti-fuse element 101. Then, Joule heat is generated in the resistor element 102, and the Joule heat transmits to the low melting point conductors 106 and 107 through the insulator 103. As a result, as shown in FIG. 16(b), the low melting point conductors 106 and 107 are fused/welded together, both of the terminals 104 and 105 are electrically connected to each other to turn to a conducting state, and the current is flown through the anti-fuse element while detouring the LED. Then, in such a way, even if a part of the LEDs causes the opening failure, the other LEDs connected in series thereto become capable of ensuring such a normal lighting operation.

Moreover, as another prior art related to the anti-fuse element, a semiconductor device described in Patent Literature 2 is known. The semiconductor device includes: a semiconductor substrate; a first Al wire formed on the semiconductor substrate; a first electrode formed on the first Al wire and electrically connected to the first Al wire; a second Al wire formed on the semiconductor substrate; a second wire formed on the second Al wire and electrically connected to the second Al wire; and an anti-fuse film in contact with the first and second electrodes. In the semiconductor device, the first and second electrodes are made of barrier metal to Al, and the anti-fuse film is formed of SiNₓ in which an atomic composition ratio is set at a predetermined ratio.

This Patent Literature 2 relates to an anti-fuse element for use in a field programmable gate array (FPGA). Specifically, an insulator made of SiNₓ is interposed as the anti-fuse film between the first and the second electrodes, each of which is made of a barrier metal layer of Ti/TiN. In a non-program state as an initial state, the anti-fuse element exhibits insulating properties, and in a program state where a predetermined voltage is applied thereto, the anti-fuse element lowers resistance thereof to be allowed to turn to the conducting state, and thereby enables a program to be electrically written.

### Prior Art Literature

### Patent Literature

Patent Literature 1: Japanese Patent Laid-Open Publication No. 2007-329275
Patent Literature 2: Japanese Patent Laid-Open Publication No. H07-22513

### DISCLOSURE OF THE INVENTION

### Problem to be solved by the invention

In Patent Literature 1, at the time of the opening failure, the low melting point conductors 106 and 107 are fused, and both thereof are welded together, and accordingly, can be electrified with each other stably at low resistance. However, in the case where a resistance value of the resistor element 102 is low, the current flows through the resistor element 102 even at the time of the normal operation. Therefore, it is apprehended that a current to flow through the LED may be lowered to reduce a light emitting amount of the LED. Meanwhile, in the case where the resistance value of the resistor element 102 is high, only a micro current flows through the anti-fuse element 101 at the time of the normal operation, and the reduction of the light emitting amount of the LED can be suppressed. However, at the time of the opening failure of the LED, it is necessary to supply the resistor element 102 with a current enough to allow the resistor element 102 to generate heat. Therefore, it is apprehended that a power supply device with a large capacity may be required to bring about a cost increase.

Moreover, the anti-fuse element in Patent Literature 2 is oriented for use in the FPGA. The resistance of the anti-fuse element is lowered by applying a predetermined voltage thereto, whereby the first electrode and the second electrode are short-circuited to turn to the conducting state, and the writing of the program is thereby enabled. That is to say, the writing of the program is an object of the anti-fuse element in Patent Literature 2, and accordingly, such a conducing portion is narrow and high resistant, and it is not assumed that a large current flows through the anti-fuse element. Meanwhile, in the case of using the anti-fuse element for a usage purpose of taking countermeasures against the opening failure of the electronic component such as the LED, it is necessary to electrify, with a large current of 10 mA or more, the anti-fuse element connected in parallel to the above-described electronic component.

Hence, even if the anti-fuse element in Patent Literature 2, which is oriented for use in the FPGA, is applied to the usage purpose of taking countermeasures against the opening failure of the electronic component, it is difficult to sufficiently exert desired effects.

Moreover, in such an electronic instrument of today, when a high voltage generated by an electrostatic discharge (hereinafter, referred to as an "ESD") is momentarily applied to an electronic circuit, it is apprehended that the electronic component may be damaged and so on. Accordingly, countermeasures against the ESD are important. Then, the anti-fuse element operates at the time of the opening failure of the electronic component, and does not operate at the time of the normal operation of the electronic component. Therefore, it is advantageous if the electronic component can be given a function as an ESD countermeasure element at the time of the normal operation of the electronic component.

The present invention has been made in consideration of the circumstances as described above. It is an object of the present invention to provide an anti-fuse element, which operates stably at low resistance even if the anti-fuse element is electrified with a large current after being activated, and has a function as the ESD countermeasure element before being activated.

### Means for solving the problem

In order to achieve the foregoing object, an anti-fuse element according to the present invention includes: an element body including a dielectric thin film and electrode films formed on both of upper and lower surfaces of the dielectric thin film, **characterized in that** the electrode films are fused by heat generation caused when an operation voltage is applied thereto, and the electrode films are welded and electrically connected to each other.

Moreover, the anti-fuse element of the present invention is **characterized in that** the electrode films are fused by the heat generation caused when the operation voltage is applied thereto, and in addition, the dielectric thin film is divided, and the electrode films are welded with each other in a mode of tangling the dielectric thin film.

Moreover, the anti-fuse element of the present invention is **characterized in that** the welded electrode films are electrified with a current of 10 mA or more.

Furthermore, the anti-fuse element of the present invention is **characterized in that** the electrode films are formed of a noble metal material.

Moreover, the anti-fuse element of the present invention is **characterized in that** the noble metal material contains at least one of Pt and Au.

Moreover, the anti-fuse element of the present invention is **characterized in that** the anti-fuse element is coated with at least one or more layers of protection films made of an organic material.

Furthermore, the anti-fuse element of the present invention is **characterized in that** the element body is formed to have a stack structure including two or more capacitance generation portions.

Moreover, the anti-fuse element of the present invention is **characterized in that**, among the two or more capacitance generation portions, the electrode films composing one capacitance generation portion are welded with each other preferentially to the electrode films composing other capacitance generation portion.

Furthermore, the anti-fuse element of the present invention is **characterized in that** the dielectric thin film composing the one capacitance generation portion is formed so that a film thickness of the dielectric thin film can be thinner than a film thickness of the dielectric thin film composing the other capacitance generation portion.

Moreover, the anti-fuse element of the present invention is **characterized in that** insulation resistance of the dielectric thin film composing the one capacitance generation portion is lower in comparison with insulation resistance of the dielectric thin film composing the other capacitance generation portion.

Furthermore, the anti-fuse element of the present invention is **characterized in that** the dielectric thin film composing the one capacitance generation portion is formed under a thin film forming condition where insulation resistance is lowered in comparison with insulation resistance of the dielectric thin film composing the other capacitance generation portion.

Moreover, the anti-fuse element of the present invention is **characterized in that** a film thickness of at least one electrode film composing the one capacitance generation portion is thicker than a film thickness of at least one electrode composing the other capacitance generation portion.

Moreover, the anti-fuse element of the present invention is **characterized in that** three or more of the capacitance generation portions are provided, and extracting electrodes that extract electric signals from the capacitance generation portions are electrically connected to the electrode films in layers different from one another.

Moreover, the anti-fuse element of the present invention is **characterized in that**, among the electrode films of the element bodies, on a surface of an uppermost electrode film, a metal film lower in resistance than the electrode film is formed.

### ADVANTAGEOUS EFFECTS OF THE INVENTION

In accordance with the anti-fuse element of the present invention, the anti-fuse element includes: the element body including the dielectric thin film and the electrode films formed on both of the upper and lower surfaces of the dielectric thin film, wherein the electrode films are fused by the heat generation caused when the operation voltage is applied thereto, and the electrode films are welded and electrically connected to each other. Accordingly, the electrode films on both of the upper and lower surfaces are easily short-circuited with each other by the application of the operation voltage, and even when the anti-fuse element is thus electrified with a large current, resistance therein is low, and a resistance value thereof after the short circuit is also stabilized.

Hence, in the case where a plurality of electronic components are connected in series to one another, the anti-fuse element is connected in parallel to each of the electronic components, whereby it becomes possible to stably continue operations of other electronic components even if a part of the electronic components causes the opening failure.

Moreover, the electrode films are fused by the heat generation caused when the operation voltage is applied thereto, and in addition, the dielectric thin film is divided, and the electrode films are welded with each other in the mode of tangling the dielectric thin film. Accordingly, the electrode films are tightly integrated with each other, and it becomes possible to realize a stable conducting state where the resistance is surely low.

Moreover, the welded electrode films are electrified with the current of 10 mA or more. Accordingly, it becomes possible to electrify the other electronic components with a desired large current while detouring a part of the electronic components which have caused the opening failure, and it becomes possible to compensate the operations of the other electronic components.

The electrode films are formed of the noble metal such as Pt and Au. Accordingly, even if the electrode films are fused by the heat generation, oxidation thereof and an increase of the resistance thereof can be avoided. Hence, even after the electrode films are welded and short-circuited with each other, such a low resistance state can be maintained so that the large current can be transmitted therethrough, and reliability of the anti-fuse element can be ensured.

Moreover, the anti-fuse element is coated with at least one or more layers of protection films made of an organic material. Accordingly, even if interlayer peeling occurs owing to the welding of the electrode films, such a peeled spot is sealed by the protection film, and hence, stable operation can be ensured, and the reliability can be ensured.

Furthermore, the element body is formed to have the stack structure including two or more capacitance generation portions. Accordingly, it becomes possible to weld the electrode films with each other in each layer, it becomes possible to further reduce the resistance value by an increase of the welded spots, and the heat generation at the time of electrification can be reduced. In addition, at the time of a normal operation, it becomes possible to increase the electrostatic capacitance, and the anti-fuse element becomes capable of functioning as the ESD countermeasure element.

Moreover, in the anti-fuse element of the present invention, among the two or more capacitance generation portions, the electrode films composing one capacitance generation portion are welded with each other preferentially to the electrode films composing other capacitance generation portion. Accordingly, such specific electrode films composing one capacitance generation portion are short-circuited with each other earlier and selectively, and it becomes possible to ensure the stable operation.

Here, "preferentially welded" refers to that the electrode films composing one capacitance generation portion are welded with each other earlier than the electrode films composing the other capacitance generation portions. In some case, the welding is also performed for the other capacitance generation portion by defining, as a starting point, the welding of the one capacitance generation portion.

That is to say, in the case where the anti-fuse element is used for such a usage purpose in which a bias is always applied, it is apprehended that a voltage may be applied thereto also at the time of the normal operation, bringing about the short circuit of the anti-fuse element. However, even in such a case, the specific electrode films are selectively short-circuited with each other, whereby it becomes possible to suppress an occurrence of an element defect, the stable operation can be ensured, and the reliability can be enhanced.

Specifically, (i) the dielectric thin film composing the one capacitance generation portion is formed so that the film thickness of the dielectric thin film can be thinner than the film thickness of the dielectric thin film composing the other capacitance generation portion, (ii) the insulation resistance of the dielectric thin film composing the one capacitance generation portion is lowered in comparison with the insulation resistance of the dielectric thin film composing the other capacitance generation portion, and (iii) the dielectric thin film composing the one capacitance generation portion is formed under the thin film forming condition where the insulation resistance is lowered in comparison with the insulation resistance of the dielectric thin film composing the other capacitance generation portion. In such a way, it becomes possible to weld the electrode films composing the one capacitance generation portion with each other preferentially to the electrode films composing the other capacitance generation portion.

Moreover, the film thickness of at least one electrode film composing the one capacitance generation portion is thicker than the film thickness of at least one electrode composing the other capacitance generation portion. In such a way, the film thickness of the welded and integrated electrode films can be thickened, the resistance thereof can be further lowered, and it becomes possible to suppress variations of the transmitting current.

Moreover, three or more of the capacitance generation portions are provided, and extracting electrodes that extract the electric signals from the capacitance generation portions are electrically connected to the electrode films in the layers different from one another. Accordingly, the extracting electrodes connected to the electrode films do not stay at the same potential thereamong, and in such a way, it becomes possible to achieve further reduction of the resistance value.

Moreover, among the electrode films of the element bodies, on the surface of the uppermost electrode film, the metal film lower in resistance than the electrode film is formed. Accordingly, after the welding and the short circuit of the electrode film, it becomes possible to flow the current preferentially to the metal film with lower resistance, and operation characteristics after the short circuit can be controlled easily. Furthermore, a noble metal material with a high melting point, which has high resistance and has oxidation resistance, is expensive in general; however, an inexpensive material such as Cu is used as the low resistance material, whereby it becomes possible to achieve cost reduction.

### BRIEF EXPLANATION OF DRAWINGS

FIG 1 is a plan view schematically showing an embodiment (first embodiment) of an anti-fuse element according to the present invention.
FIG. 2 is a cross-sectional view along a line A-A of FIG. 1.
FIGS. 3 is a view showing a mechanism in a case where the anti-fuse element is changed from an insulating state to a conducting state.
FIG. 4 is an electric circuit diagram showing an example of an electronic device on which the anti-fuse element is mounted.
FIGS. 5 is a manufacturing process view (1/3) showing an example of a manufacturing method of the anti-fuse element.
FIGS. 6 is a manufacturing process view (2/3) showing the example of the manufacturing method of the anti-fuse element.
FIGS. 7 is a manufacturing process view (3/3) showing the example of the manufacturing method of the anti-fuse element.
FIG. 8 is a plan view schematically showing a second embodiment of the anti-fuse element according to the present invention.
FIG. 9 is a cross-sectional view along a line B-B of FIG. 8.
FIG. 10 is a cross-sectional view along a line C-C of FIG. 8.
FIG. 11 is a plan view schematically showing a third embodiment of the anti-fuse element according to the present invention.
FIG. 12 is a cross-sectional view along a line D-D of FIG. 11.
FIG. 13 is a cross-sectional view along a line E-E of FIG. 11.
FIG. 14 is an FIB-SIM image showing a welded state of first and second electrodes.
FIG. 15 is a graph showing an output waveform of an electrostatic immunity test in an example of the present invention together with that of a comparative example.
FIG. 16 is a cross-sectional view of an anti-fuse element described in Patent Literature 1.

### BEST MODE FOR CARRYING OUT THE INVENTION

Next, a description is made in detail of embodiments of the present invention based on the drawings.

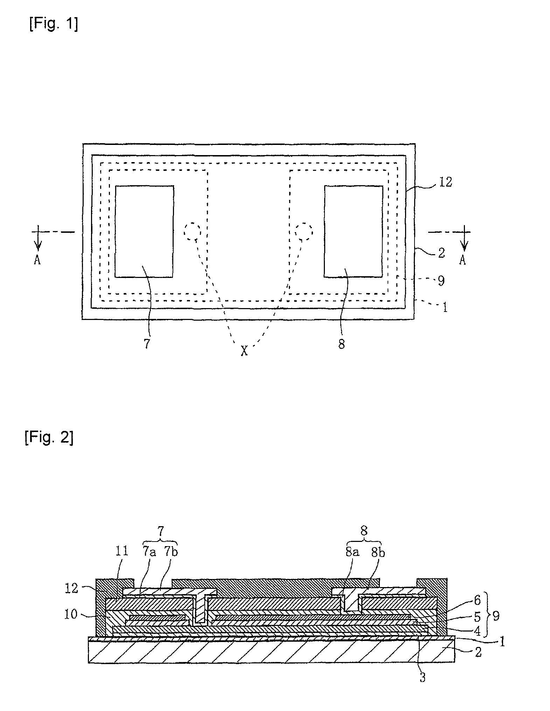

FIG. 1 is a plan view schematically showing an embodiment (first embodiment) of an anti-fuse element according to the present invention, and FIG. 2 is a cross-sectional view along a line A-A of FIG. 1.

In this anti-fuse element, an adhesion layer 3 is formed on a Si single crystal substrate (hereinafter, simply referred to as a "Si substrate") 2 on a surface of which an oxide layer 1 made of SiO₂ is formed. On an upper surface of the adhesion layer 3, there are sequentially formed: a first electrode film 4; a dielectric thin film 5 as an insulator layer; and a second electrode film 6. Then, the first electrode film 4 is electrically connected to a first extracting electrode 7, the second electrode film 6 is electrically connected to a second extracting electrode 8, and the anti-fuse element is composed so as to be connectable in parallel to an electronic component such as an LED by the first and second extracting electrodes 7 and 8. Note that the first electrode film 4, the dielectric thin film 5 and the second electrode film 6, which are mentioned above, form an element body 9. Moreover, at substantial center portions in a width direction of the anti-fuse element, the first electrode film 4 and the first extracting electrode 7 are electrically connected to each other, and the second electrode film 6 and the second extracting electrode 8 are electrically connected to each other (connection portions are shown by reference symbol X in FIG. 1) .

As a conductive material for use in the first and second electrode films 4 and 6, a material is used, which is capable of transmitting therethrough a large current of 10 mA or more, and has low resistance, in which the resistance after activation is stabilized. That is to say, there can be preferably used a noble metal material, such as Pt or Au, with a high melting point, which is not oxidized or does not increase resistance thereof even if being heated and fused by heat generated by such electrification when an operation voltage is applied thereto. Note that a film thickness of the first and second electrode films 4 and 6 is not particularly limited as long as it is appropriate; however, is preferably set at 100 to 500 nm.

Moreover, as a thin film material for use in the dielectric thin film 5, a dielectric material having a high dielectric constant is used. Specifically, there can be used (Ba,Sr)TiO₃ (hereinafter, referred to as "BST"), SrTiO₃, BaTiO₃, Pb(Zr,Ti)O₃, a bismuth-layered compound such as SrBi₄Ti₄O₁₅, and the like. Among them, BST is preferably used.

Moreover, a film thickness of the dielectric thin film 5 is set at such a film thickness that enables the dielectric thin film 5 to be broken and divided by the heat generated by the electrification, and that makes it possible to ensure a large electrostatic capacitance, and is preferably set at approximately 80 to 150 nm.

As described above, the dielectric thin film 5 having the high dielectric constant is used as the insulator layer, whereby it becomes possible to obtain the large electrostatic capacitance unlike in the case of using a SiO₂ film or a SiNₓ film as the insulator layer. Then, as a result, momentary application of a high voltage by static electricity can be reduced, and the anti-fuse element can be enabled to function as an ESD countermeasure element.

That is to say, it is an object of the anti-fuse element of the present invention to short-circuit and operate the first and second electrode films 4 and 6; however, until short-circuiting the first and second electrode films 4 and 6, the anti-fuse element has the function as the ESD countermeasure element that dissipates the static electricity to the ground. Note that, in the case of functioning as the ESD countermeasure element, the anti-fuse element does not short-circuit the first and second electrode films 4 and 6, and accordingly, does not involve a dielectric breakdown at the time of discharge.

Moreover, each of the first and second extracting electrodes 7 and 8 is formed to have a two-layer structure. The first extracting electrode 7 includes: a first layer 7a formed of Ti or the like; and a second layer 7b formed of Cu or the like, and the second extracting electrode 8 includes: a first layer 8a formed of Ti or the like; and a second layer 8b formed of Cu or the like. The first layers 7a and 8a are formed, for example, to 100 nm, and the second layers 7b and 8b are formed, for example, to 1000 nm.

Furthermore, an upper surface and side surface of the element body 9 are coated with an inorganic protection film 10 with a film thickness of 200 to 1000 nm, and a first organic protection film 11 with a film thickness of 2000 to 10000 nm is formed on the inorganic protection film 10.

Note that SiNₓ, SiO₂, Al₂O₃, TiO₂ or the like can be used for the inorganic protection film 10, and that polyimide resin, epoxy resin or the like can be used for the first organic protection film 11.

A second organic protection film 12 is formed so as to coat the inorganic protection film 10 and the first organic protection film 11, and to partially expose surfaces of the first and second extracting electrodes 7 and 8. In a similar way to the first organic protection film 11, the polyimide resin, the epoxy resin or the like can be used also for the second organic protection film 12.

The element body 9 is coated with the first and second organic protection films 11 and 12 as described above. In such a way, even in the case where interlayer peeling occurs between the element body 9 and the adhesion layer 3 and the like by the welding of the first and second electrode films 4 and 6, the element body 9 after the welding is sealed by the first and second organic protection films 11 and 12. Hence, the anti-fuse element can be stably operated, and reliability thereof can be ensured.

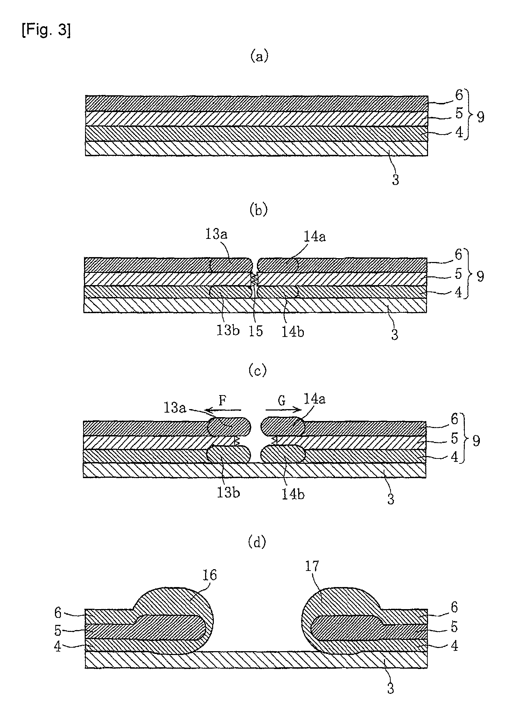

FIGS. 3 is a view showing a mechanism in a case where the above-described anti-fuse element is changed from an insulating state to a conducting state.

Specifically, when the electronic component connected in parallel to the anti-fuse element operates normally, then as shown in FIG. 3(a), the first and second electrode films 4 and 6 are in the insulating state while interposing the dielectric thin film 5 therebetween.

However, when the electronic component turns to an opening state by a breakage and the like, the operation voltage is applied to the anti-fuse element, and the large current of 10 mA or more, which should flow through the electronic component, flows into the element body 9. Then, Joule heat is generated to cause heat generation in the element body 9. Then, as shown in FIG. 3(b), by this heat generation, the first and second electrode films 4 and 6 are fused, and cause balling phenomena at predetermined spots thereof to be short-circuited. In such a way, the first and second electrode films 4 and 6 form balled portions 13a, 13b, 14a and 14b, and are divided. Moreover, by fusion heat from the balled portions 13a, 13b, 14a and 14b, the dielectric thin film 5 is heated, and thus a crack 15 is generated.

Also thereafter, the current continuously flows into the element body 9. Accordingly, as shown in FIG. 3(c), the fusion of the first and second electrode films 4 and 6 further progresses with an elapse of time, and the balled portions 13a, 13b, 14a and 14b are enlarged in directions shown by arrows F and G, and the dielectric thin film 5 is completely divided by the fusion heat.

Thereafter, the balled portions 13a, 13b, 14a and 14b are further enlarged, and as shown in FIG. 3(d), the enlarged balled portions are welded and integrated together in such a mode of tangling end portions of the divided dielectric thin film 5, and form bonded portions 16 and 17. In such a way, the anti-fuse element turns to the conducting state. Then, when the anti-fuse element turns to the conducting state as described above, the heat generation by the electrification is suppressed to lower a temperature thereof, and to further lower resistance thereof, and the large current comes to flow through the anti-fuse element.

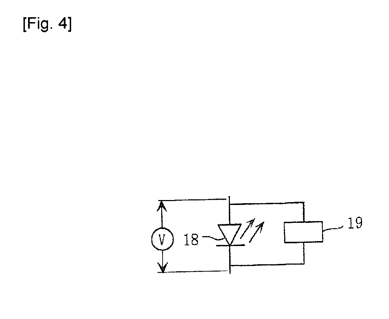

FIG. 4 shows an electric circuit diagram in a case where the anti-fuse element is connected in parallel to an LED as the electronic component.

Specifically, in the case where an LED 18 causes the opening failure to thereby turn off, first and second electrode films of an anti-fuse element 10 connected in parallel to the LED 18 are welded and short-circuited with each other by the above-mentioned mechanism, and turns from the insulating state to the conducting state. Then, the current flows into the anti-fuse element 19 while detouring the LED 18, whereby, for example, other electronic components connected in series to the LED 18 maintain the conducting state. For example, in the case where other LEDs are connected in series to the LED 18, the anti-fuse element 19 of the present invention is electrified while detouring the LED 18, and the other LEDs continue to turn on.

As described above, the anti-fuse element of the present invention is used, whereby, even if a part of the electronic components connected in series to one another fails and turns to an open state, it becomes possible for the other electronic components to operate normally. In addition, the first and second electrode films formed of the high melting point noble metal material including Pt or Au are fused/welded and short-circuited with each other, accordingly, are not oxidized or do not increase resistance thereof even if being heated and fused, and can maintain low resistance. Hence, the anti-fuse element can operate stably even when being electrified with a large current, and a power supply with a large capacity is unnecessary, too.

Moreover, in the element body 9 of the anti-fuse element connected in parallel to the electronic component that does not cause the opening failure, the dielectric thin film 5 uses the material with the high dielectric constant as mentioned above. Accordingly, the dielectric thin film 5 can increase the electrostatic capacitance, thus making it possible to reduce excessive voltage application caused by the static electricity. In such a way, the anti-fuse element has the function as the ESD countermeasure element.

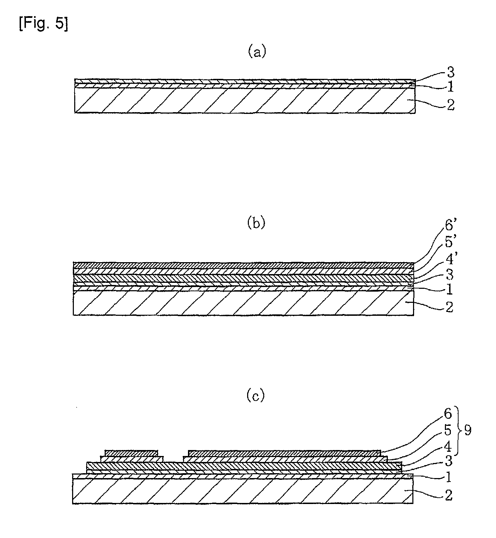

Next, a description is made below in detail of a manufacturing method of the above-described anti-fuse element based on FIG. 5 to FIG. 7.

First, as shown in FIG. 5(a), thermal oxidation treatment is implemented for the Si substrate 2, and the oxide layer 1 made of SiO₂ with a film thickness of 500 to 1000 nm is formed.

Subsequently, the adhesion layer 3 with a film thickness of 10 to 100 nm is formed on the oxide layer 1 by a chemical solution deposition (hereinafter, referred to as "CSD") method. As the adhesion layer 3, there can be used BST, SrTiO₃, BaTiO₃, Pb(Zr,Ti)O₃, a bismuth-layered compound such as SrBi₄Ti₄O₁₅, and the like. For example, in the case of forming a BST film, a film-forming raw material solution is prepared, in which Ba, Sr, Ti are blended, for example, in a molar ratio of 7: 3: 10. Then, this film-forming raw material solution is applied on the oxide layer 1, is dried on a hot plate of 300 to 400°C, is subjected to heat treatment at a temperature of 600 to 700°C for 10 to 60 minutes, and is thereby crystallized. In such a way, the BST film is formed.

Next, as shown in FIG. 5(b), a first conductive layer 4', an insulator layer 5' and a second conductive layer 6' are sequentially film-formed. Specifically, the first conductive layer 4' made of Pt or Au with a film thickness of 100 to 500 nm is formed by an RF magnetron sputtering method. Subsequently, in a similar way to the adhesion layer 3, the insulator layer 5' with a film thickness of 80 to 150 nm, which is made of BST or the like, is formed by the CSD method. Thereafter, in a similar way to the first conductor layer 4', the second conductive layer 6' made of Pt or Au with a film thickness of 100 to 500 nm is formed by the RF magnetron sputtering method.

Next, as shown in FIG. 5(c), the second electrode film 6, the dielectric thin film 5 and the first electrode film 4 are fabricated by using a photolithography technology and an argon ion milling method. That is to say, after photoresist is applied on a resultant from FIG. 5(b), followed by prebaking, an ultraviolet ray is directed onto the photoresist through a photomask, and exposure, development and post-baking are performed therefor, whereby a photomask pattern is transferred to a resist pattern. Subsequently, by the argon ion milling method, argon ions are allowed to collide with etching surfaces to thereby etch predetermined regions of the second conductive layer 6', the insulator layer 5' and the first conductive layer 4', whereby the second electrode film 6, the dielectric thin film 5 and the first electrode film 4 are sequentially formed. In such a way, the device body 9 is fabricated.

Thereafter, this element body 9 is subjected to heat treatment at a temperature of 800 to 900°C for approximately 30 minutes.

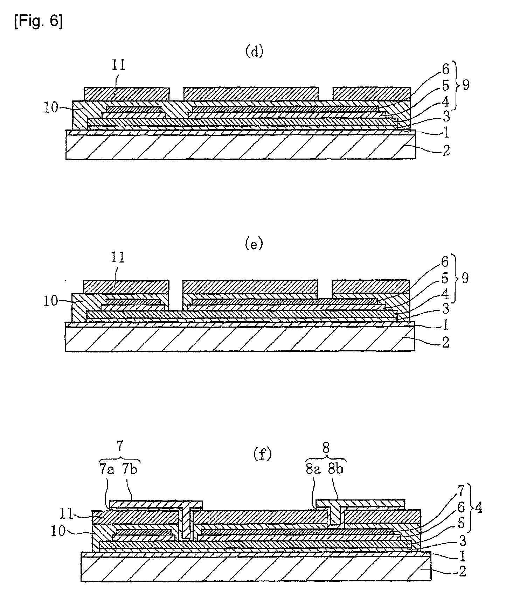

Next, as shown in FIG. 6(d), the inorganic protection film 10 with a film thickness of 200 to 1000 nm is formed by the sputtering method so as to cover the upper surface and side surface of the element body 9. Subsequently, a photosensitive resin material is applied on the inorganic protection film 10 by a spin coating method, is thereafter heated at a temperature of 125°C for 5 minutes, and is subjected to exposure and development treatments. Thereafter, the photosensitive resin material is heated at 350°C for approximately 1 hour, whereby the first organic protection film 11 having a predetermined pattern, in which a film thickness is 2000 to 10000 nm, is formed.

Next, the inorganic protection film 10 is dry-etched by using CHF₃ gas while using this first organic protection film 11 as a mask, and as shown in FIG. 6(e), surfaces of the first electrode film 4 and the second electrode film 6 are partially exposed.

Next, by using the RF magnetron sputtering method, two metal layers which should serve as the first and second extracting electrodes 7 and 8 are formed. Subsequently, a photomask pattern is transferred to a resist pattern by using the above-mentioned photolithography technology, and is etched by using the argon ion milling method. In such a way, as shown in FIG. 6(f), the first extracting electrode 7 including the first layer 7a and the second layer 7b is formed, and the second extracting electrode 8 including the first layer 8a and the second layer 8b is formed.

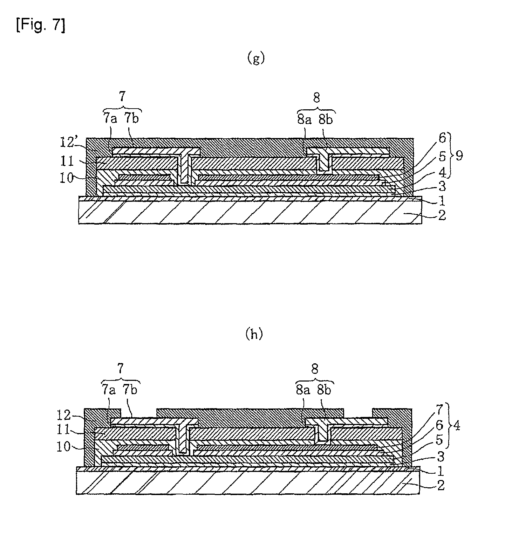

Next, as shown in FIG. 7(g), by the spin coating method, a photosensitive resin raw material 12' is applied so as to cover the first and second extracting electrodes 7 and 8, and further, to cover the inorganic protection film 10 and the first organic protection film 11. Thereafter, the photosensitive resin raw material 12' is heated at 125°C for 5 minutes, is subjected to exposure and development steps, and is heated at 350°C for approximately 1 hour. In such a way, as shown in FIG. 7(h), the second organic protection film 12 having a predetermined pattern, in which a film thickness is 2000 to 10000 nm, is formed, whereby the anti-fuse element is fabricated.

Then, as mentioned above, this anti-fuse element includes the element body 9 including: the dielectric thin film 5; and the first and second electrode films 4 and 6 formed on both of the upper and lower surfaces of the dielectric thin film 5. In the anti-fuse element, the first and second electrode films 4 and 6 are fused by the heat generation that occurs at the time of applying the operation voltage, and these first and second electrode films 4 and 6 are welded and electrically connected to each other. Accordingly, by the application of the operation voltage, the first electrode film 4 and the second electrode film 6 are short-circuited with each other, and become capable of transmitting the large current therebetween. Even when the anti-fuse element is thus electrified with the large current, the resistance therein is low, and the resistance value thereof after the short circuit is also stabilized. Accordingly, the anti-fuse element is connected in parallel to each of the electronic components in the case where the plurality of electronic components are connected in series to one another, whereby it becomes possible to effectively compensate the operations of the other electronic components even if the specific electronic component causes the opening failure.

In addition, the first electrode film 4 and the second electrode film 6 are welded and bonded to each other in the mode of tangling the dielectric thin film 5 as mentioned above. Accordingly, the electrode films are tightly integrated with each other, and such a conducting state where it is possible to transmit the large current of 10 mA or more can be surely realized.

Moreover, the first and second electrode films 4 and 6 are formed of the high melting point metal material such as Pt and Au, and accordingly, are not oxidized or do not increase the resistance thereof even when being fused by the heat generation. Hence, even after the first electrode film 4 and the second electrode film 6 are welded and short-circuited with each other, such a low resistance state can be maintained so that the large current can be transmittable therethrough, and reliability of the anti-fuse element can be ensured.

Moreover, the element body 9 is coated with the first organic protection film 11 and the second organic protection film 12. Accordingly, even if interlayer peeling among the respective layers occurs owing to the welding of the first electrode film 4 and the second electrode film 6, the element body 9 is sealed by the organic protection films. Hence, a stable operation of the anti-fuse element can be ensured, and the reliability can be ensured.

Moreover, the element body 9 has a structure in which the electrode films (first and second electrode films 4 and 6) are formed on both of the upper and lower surfaces of the dielectric thin film 5, and accordingly, it becomes possible to obtain the large electrostatic capacitance before the application of the operation voltage. Hence, when the electronic component connected in parallel to the anti-fuse element operates normally, the anti-fuse element can exert the function as the ESD countermeasure element.

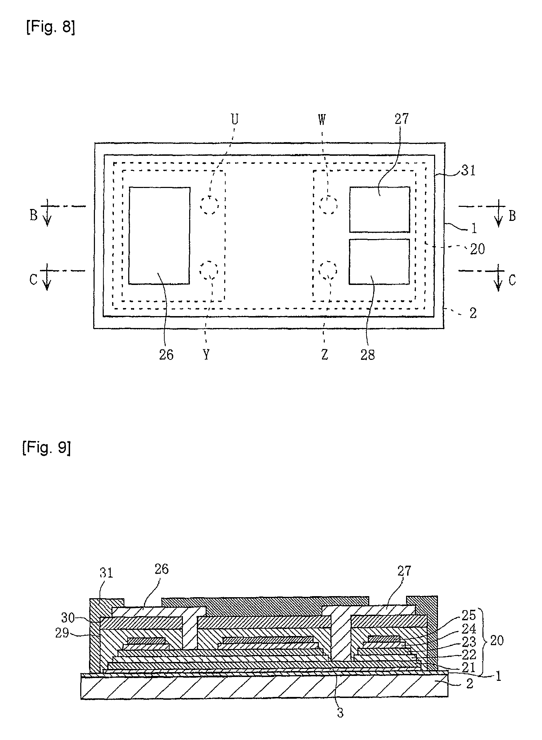

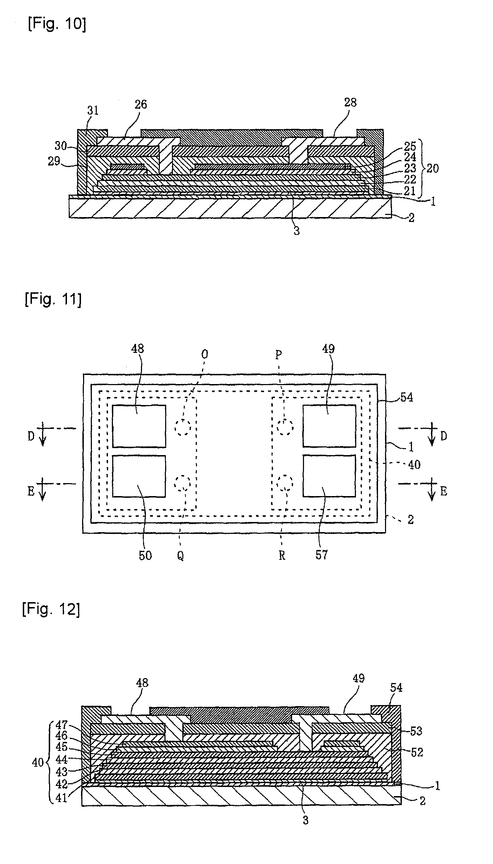

FIG. 8 is a plan view showing a second embodiment of the anti-fuse element according to the present invention, FIG. 9 is a cross-sectional view along a line B-B of FIG. 8, and FIG. 10 is a cross-sectional view along a line C-C of FIG. 8.

In this second embodiment, an element body 20 is formed into a stack structure, and has two capacitance generation portions. That is to say, on the upper surface of the adhesion layer 3, there are sequentially film-formed a first electrode film 21, a first dielectric thin film 22, a second electrode film 23, a second dielectric thin film 24, and a third electrode film 25, and with this configuration, the element body 20 is formed. Then, electrostatic capacitance is generated by the first electrode film 21, the first dielectric thin film 22, and the second electrode film 23, electrostatic capacitance is generated by the second electrode film 23, the second dielectric thin film 24, and the third electrode film 25, whereby two capacitance generation portions are provided.

Moreover, the second electrode film 23 is electrically connected to a first extracting electrode 26, the first electrode film 21 is electrically connected to a second extracting electrode 27, and further, the third electrode film 25 is electrically connected to a third electrode film 28. That is to say, in a similar way to the first embodiment, the first to third extracting electrodes 26 to 28 are formed to have a two-layer structure (not shown in FIGS. 9 and 10). In FIG. 8, the second electrode film 23 and the first extracting electrode 26 are electrically connected to each other at a U portion and a Y portion, the first electrode film 21 and the second extracting electrode 27 are electrically connected to each other at a W portion, and the third electrode film 25 and the second extracting electrode 28 are electrically connected to each other at a Z portion.

Furthermore, in a similar way to the first embodiment, the element body 20 is coated with an inorganic protection film 29 and first and second organic protection films 30 and 31.

Then, also in this case, when the operation voltage is applied to the anti-fuse element, in a similar way to the first embodiment, a current flows into the element body 20 to cause the heat generation therein, the electrode films are fused together by this heat generation, and the electrode films are welded and short-circuited with each other, and turn to the conducting state.

Moreover, before the application of the operation voltage, the anti-fuse element exerts the function as the ESD countermeasure element. In particular, in this second embodiment, since the element body 20 is formed to have the stack structure including two capacitance generation portions, the electrostatic capacitance of the element body 20 can be increased in comparison with the case of a single layer structure, and the reduction of the ESD can be performed far more effectively.

The anti-fuse element of this second embodiment can also be easily manufactured by substantially similar method/procedure to those of the first embodiment.

That is to say, after the oxide layer 1 and the adhesion layer 3 are film-formed on the surface of the Si substrate 2, a first metal layer made of Pt or Au is film-formed on the surface of the adhesion layer 3 by the RF magnetron sputtering method, and further, a first insulator layer made of BST or the like is film-formed on the first metal layer by the CSD method.

Subsequently, a second metal layer made of Pt or the like is film-formed on the first insulator layer by the RF magnetron sputtering method, and further, a second insulator layer made of BST or the like is film-formed on the second metal layer by the CSD method.

Then, thereafter, a third metal layer is film-formed on a surface of the second insulator layer by the RF magnetron sputtering method.

Next, a resultant thus obtained is patterned by using the photolithography technology, and thereafter, argon is allowed to collide with an etching surface by the argon ion milling method, whereby etching is performed. In such a way, the third electrode film 25, the second dielectric thin film 24, the second electrode film 23, the first dielectric thin film 22 and the first electrode film 21 are sequentially formed, whereby the element body 20 is fabricated.

Thereafter, in a similar way to the first embodiment, the element body 20 is subjected to the heat treatment, and there are sequentially fabricated: the inorganic protection film 29 made of SiNₓ or the like; the first organic protection film 30 made of polyimide resin or the like; and the first to third extracting electrodes 26 to 28 formed of the two-layer structure. Thereafter, the second organic protection film 31 made of polyimide resin or the like is fabricated, whereby the anti-fuse element is manufactured.

Moreover, a variety of modification examples are possible for this anti-fuse element having the stack structure. For example, it is also preferable that, between the two capacitance generation portions, the electrode films composing one of the capacitance generation portions be welded and short-circuited with each other preferentially to the electrode films composing the other capacitance generation portion. In such a way, the electrode films composing one of the capacitance generation portions are short-circuited with each other earlier and selectively, and it becomes possible to ensure a stable operation.

As effective methods of short-circuiting the electrode films of one of the capacitance generation portions with each other preferentially to the electrode films of the other capacitance generation portion, there are methods to be described below.

(i) The film thickness of the dielectric thin film (for example, the second dielectric thin film 24) composing one of the capacitance generation portions is thinned, for example, by approximately 20% than the film thickness of the dielectric thin film (for example, the first dielectric thin film 22) composing the other capacitance generation portion.

A probability that the electrode films of the element body 20 may be bonded and short-circuited with each other by application of a bias is inversely proportional to the film thickness of the dielectric thin film. Hence, the dielectric thin film (for example, the second dielectric thin film 24) interposed between the electrode films (for example, the second and third electrode films 23 and 25) desired to be short-circuited with each other earlier is thinned. In such a way, in comparison with the case where the film thickness of the dielectric thin film is set the same as the film thickness of the second dielectric thin film, it becomes easy to short-circuit such a specific dielectric thin film, and the reliability of the anti-fuse element can be enhanced.

(ii) For example, by using the following methods (a) to (c), insulation resistance of the dielectric thin film (for example, the second dielectric thin film 24) composing one of the capacitance generation portions is lowered in comparison with that of the dielectric thin film (for example, the first dielectric thin film 22) composing the other capacitance generation portion.

(a) In the case where the dielectric thin film of the capacitance generation portion desired to be short-circuited is the second dielectric thin film 24, materials of the second dielectric thin film 24 are selected so that the insulation resistance of the second dielectric thin film 24 is lower in comparison with that of the first dielectric thin film 22. For example, in the case where the first dielectric thin film 22 is formed of BST, such other materials lower in insulation resistance than BST are selected as the second dielectric thin film 24.

(b) In the case where both of the first and second dielectric thin films 22 and 24 are formed of BST, a composition ratio of an A site and a B site of each of the first and second dielectric thin films 22 and 24 is adjusted so that the second dielectric thin film 24 can be lower in insulation resistance than the first dielectric thin film 22.

(c) A specific element is added to the second dielectric thin film 24, whereby the insulation resistance of the second dielectric thin film 24 is also lowered than the insulation resistance of the first dielectric thin film 22. For example, in the case of using a BST material as a thin film material of both of the first and second dielectric thin films 22 and 24, a rare earth element such as Y is added to the second dielectric thin film 24, whereby the insulation resistance of the second dielectric thin film 24 is lowered than the insulation resistance of the first dielectric thin film 22.

By using the methods (a) to (c) as described above, the insulation resistance of the second dielectric resistance 24 can be lowered than the insulation resistance of the first dielectric thin film 22, whereby it becomes possible to short-circuit the second dielectric thin film 24 preferentially to the first dielectric thin film 22.

(iii) The dielectric thin film (for example, the second dielectric thin film 24) composing one of the capacitance generation portions is formed under such a thin film forming condition that the insulation resistance thereof is lowered in comparison with the dielectric thin film (for example, the first dielectric thin film 22) composing the other capacitance generation portion.

For example, in the case where the dielectric thin film of the capacitance generation portion desired to be short-circuited is the second dielectric thin film 24, at the time of forming the second dielectric thin film 24, an etching time in the argon ion milling method is elongated on purpose, and damage is given to the first dielectric thin film 22 in advance. In such a way, the insulation resistance of the second dielectric thin film 24 is lowered than the insulation resistance of the first dielectric thin film 22. The first and second dielectric thin films 22 and 24 are formed in advance as described above, whereby it becomes easy to divide the second dielectric thin film 24 in the case where the second dielectric thin film 24 is fused and heated, and it becomes possible to preferentially weld and short-circuit the second electrode film 23 and the third electrode film 25 with each other.

By using the methods (i) to (iii) as described above, the specific capacitance generation portion is preferentially welded and short-circuited, whereby a defect occurrence rate of the element can be reduced.

Moreover, preferably, at least one (for example, the third electrode film 25) of the electrode films composing one capacitance generation portion is formed so that the film thickness thereof can be thicker than the film thickness of one (for example, the second electrode film 23) of the electrode films composing the other capacitance generation portion. In such a way, the film thickness of the welded and integrated electrode films can be thickened, and accordingly, the resistance thereof is further lowered, and variations of the transmitting current can also be suppressed.

Furthermore, preferably, between the second and third electrode films 23 and 25 desired to be short-circuited with each other, on the surface of the third electrode film 25 located on the uppermost layer, a metal film lower in resistance than the third electrode film 25 is formed. In such a way, after the welding and the short circuit, it becomes possible to flow the current preferentially to the metal film with lower resistance, and operation characteristics after the short circuit can be controlled easily. In particular, the noble metal material with a high melting point, which has high resistance and has oxidation resistance, is expensive in general; however, the above-described metal film is formed of an inexpensive material such as Cu, whereby it becomes possible to achieve cost reduction.

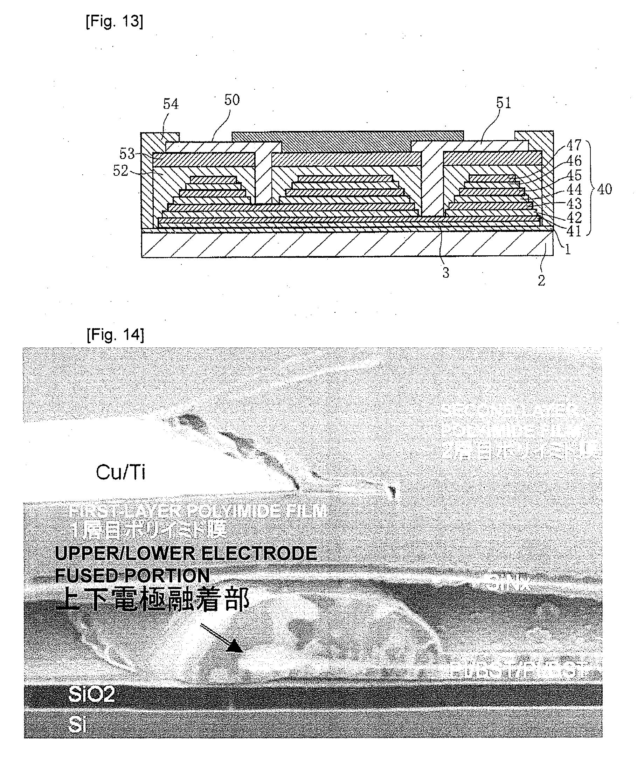

FIG. 11 is a plan view showing a third embodiment of the anti-fuse element according to the present invention, FIG. 12 is a cross-sectional view along a line D-D of FIG. 11, and FIG. 13 is a cross-sectional view along a line E-E of FIG. 11.

In this third embodiment, an element body 40 is formed to have a stack structure including three capacitance generation portions. Specifically, on the upper surface of the adhesion layer 3, there are sequentially formed a first electrode film 41, a first dielectric thin film 42, a second electrode film 43, a second dielectric thin film 44, a third electrode film 45, a third dielectric thin film 46, and a fourth electrode film 47, and these form the element body 40.

Then, the fourth electrode film 47 is electrically connected to a first extracting electrode 48 at an O portion in FIG. 11, and the third electrode film 45 is electrically connected to a second extracting electrode 49 at a P portion in FIG. 11. Moreover, the second electrode film 43 is electrically connected to a third extracting electrode 50 at a Q portion in FIG. 11, and the first electrode film 41 is electrically connected to a fourth extracting electrode 51 at an R portion in FIG. 11. That is to say, the first to fourth extracting electrodes 48 to 51 are electrically connected to the electrode films (the first to fourth electrode films 41, 43, 45, 47) in layers different from one another. Note that, in a similar way to the first embodiment, each of these extracting electrodes 48 to 51 is formed to have a two-layer structure (not shown in FIGS. 12 and 13).

Moreover, in a similar way to the first and second embodiment, the element body 40 is coated with an inorganic protection film 52 and first and second organic protection films 53 and 54.

Then also in this case, when the operation voltage is applied to the anti-fuse element, in a similar way to the first and second embodiments, a current flows into the element body 40 to cause the heat generation therein, the electrode films are fused together by this heat generation, and the electrode films are welded and short-circuited with each other, and turn to the conducting state.

Moreover, in the above-described second embodiment, an electric signal from the third electrode film 25 is extracted by the first extracting electrode 26, and the extracting electrode is at the same potential at the U portion and Y portion of FIG. 8. However, in this third embodiment, as shown in FIG. 11 to FIG. 13, the respective extracting electrodes 48 to 51 are connected to the electrode films 41, 43, 45 and 47 in the layers different from one another, and accordingly, the extracting electrodes do not stay at the same potential thereamong. In such a way, it becomes possible to achieve further reduction of the resistance value.

Moreover, before the application of the operation voltage, the anti-fuse element exerts the function as the ESD countermeasure element. In particular, in this third embodiment, since the element body 40 includes three capacitance generation portions, the electrostatic capacitance of the element body 40 can be increased in comparison with the case of the single layer structure and the two-layer structure, and the reduction of the ESD can be performed far more effectively.

The anti-fuse element of this third embodiment can also be easily manufactured by substantially similar method/procedure to those of the first embodiment.

That is to say, after the oxide layer 1 and the adhesion layer 3 are film-formed on the surface of the Si substrate 2, a first metal layer made of Pt or Au is film-formed on the surface of the adhesion layer 3 by the RF magnetron sputtering method, and further, a first insulator layer made of BST or the like is film-formed on the first metal layer by the CSD method.

Subsequently, a second metal layer made of Pt or the like is film-formed on the first insulator layer by the RF magnetron sputtering method, and further, a second insulator layer made of BST or the like is film-formed on the second metal layer by the CSD method.

Then, thereafter, a third metal layer is film-formed on a surface of the second insulator layer by the RF magnetron sputtering method, and further, a third insulator layer made of BST or the like is film-formed on the third metal layer by the CSD method.

Subsequently, a fourth metal layer made of Pt or the like is formed on the third insulator layer by the RF magnetron sputtering method.

Next, a resultant thus obtained is patterned by using the photolithography technology, and thereafter, argon is allowed to collide with an etching surface by the argon ion milling method, whereby etching is performed. In such a way, the fourth electrode film 47, the third dielectric thin film 46, the third electrode film 45, the second dielectric thin film 44, the second electrode film 43, the first dielectric thin film 42 and the first electrode film 41 are sequentially formed, whereby the element body 40 is fabricated.

Thereafter, in a similar way to the first and second embodiments, the element body 40 is subjected to the heat treatment, and there are sequentially fabricated: the inorganic protection film 52 made of SiNₓ or the like; the first organic protection film 53 made of polyimide resin or the like; and the first to fourth extracting electrodes 48 to 51 formed of the two-layer structure. Thereafter, the second organic protection film 54 made of polyimide resin or the like is fabricated, whereby the anti-fuse element is manufactured.

Note that the present invention is not limited to the above-described embodiments. Also in this third embodiment, by substantially similar methods to the methods (i) to (iii) mentioned in the second embodiment, the electrode thin films composing one capacitance generation portion among the three capacitance generation portions can be welded and short-circuited with each other preferentially to the electrode films composing the other capacitance generation portions. Then, the electrode films composing one capacitance generation portion are short-circuited with each other earlier and selectively as described above, whereby it becomes possible to ensure a more stable operation.

Moreover, in the above-described embodiments, the respective electrode films are formed by the RF magnetron sputtering method; however, the respective electrode films may be formed by other thin film forming methods such as a vacuum evaporation method.

Furthermore, in the above-described embodiments, the first organic protection films 11, 29 and 53 are formed on the inorganic protection films 10, 28 and 52, respectively; however, may be formed so as to cover side surfaces of the inorganic protection films 10, 28 and 52.

Moreover, the element body can also be formed to have a multi-layer structure including four or more capacitance generation portions.

Furthermore, though the LED is illustrated as the electronic component in FIG. 4, the present invention can be widely applied to the case where a large number of electronic components are connected in series to one another, and needless to say, the present invention can also be applied to the case where Zener diodes, varistors and the like are implemented on a circuit board.

Next, a description is specifically made of examples of the present invention.

### Example 1

Samples in which a trigger voltage was set at 20V were fabricated in accordance with the manufacturing method described above in the first embodiment. Note that electrostatic capacitance of the samples, which was measured at 1 kHz, was 0.015 µF.

Table 1 shows forming materials, film thicknesses and forming methods of the respective layers.

**[Table 1]**

| Name of Layer | | Forming Material | Film Thickness (nm) | Forming Method/Condition |
|---|---|---|---|---|
| Oxide layer | | SiO₂ | 700 | thermal oxidation treatment |
| Adhesion layer | | BST (Ba_{0.7}Sr_{0.3}TiO₃) | 50 | CSD method |
| | | | | drying condition: 350°C |
| | | | | heat treatment condition: 650°C, 30 minutes |
| First electrode film | | Pt | 300 | RF magnetron sputtering method |
| | | | | → photolithography |
| | | | | → argon ion milling method |
| Dielectric thin film | | BST (Ba_{0.7}Sr_{0.3}TiO₃) | 100 | CSD method |
| | | | | drying condition: 350°C |
| | | | | heat treatment condition: 650°C, 30 minutes |
| | | | | → photolithography |
| | | | | → argon ion milling method |
| Second electrode film | | Pt | 300 | RF magnetron sputtering method |
| | | | | → photolithography |
| | | | | → argon ion milling method |
| Thin film capacitor | | pt-BST-Pt | - | heat treatment condition: 800°C, 30 minutes |
| First and second extracting electrodes | First layer | Ti | 100 | RF magnetron sputtering method |
| | Second layer | Cu | 1000 | → photolithography → photolithography |
| | | | | → argon ion milling method |
| Inorganic protection film | | SiNₓ | 300 | sputtering method → dry etching |
| First organic protection film | | polyimide resin | 2000 | spin coating method → heating at 120°C for 5 minutes → exposure/development → heating at 350°C for 1 hour |
| Second organic protection film | | polyimide resin | 2000 | spin coating method → heating at 120°C for 5 minutes → exposure/development → heating at 350°C for 1 hour |

Next, the samples were connected to a constant current circuit in which a maximum current was set at 300 mA, and resistance values thereof after operations were measured. As a result, an average value of the resistance values was 1.2 Ω (maximum: 1.7 Ω; minimum: 0.7 Ω; n: 20), and it was understood that the samples operated stably. Moreover, it was confirmed that the resistance values were not changed even if the maximum current was changed from 50 mA to 1.0 A.

Next, for the above-described samples, a cross-section of each thereof at a welded spot where the first electrode film and the second electrode film were welded with each other was observed by a focused ion beam-scanning ion microscope (FIB-SIM) method.

FIG. 14 is an image of the FIB-SIM.

As apparent from FIG. 14, it was confirmed that, at the welded spot (a portion written as an upper/lower electrode fused portion in the image) of the first and second electrode films, though peeling occurred with the adhesion layer (BST film), the welded spot was sealed by the first organic protection film (the first-layer polyimide film).

Next, for the example of the present invention, in which each of the above-described samples was connected to an ESD generator, and for a comparative example in which each of the above-described samples was not connected to the ESD generator, an ESD immunity test was performed by applying a voltage of 1.0 kV thereto in conformity with IEC 61000-4-2.

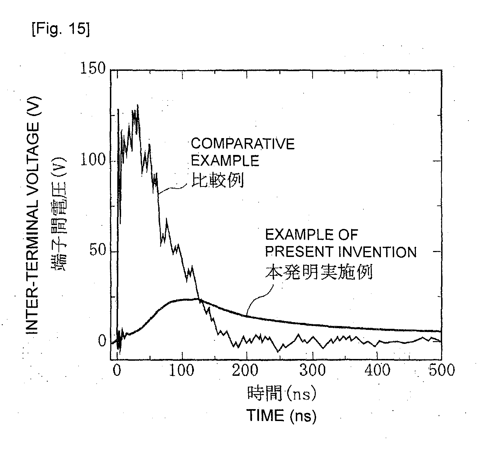

FIG. 15 is a graph showing output waveforms in the ESD immunity test, in which an axis of abscissas represents a time (ns), and an axis of ordinates represents an inter-terminal voltage (V).

As apparent from FIG. 15, in the comparative example, a steep discharge peak occurred, and a high voltage was momentarily applied between terminals of the sample. As opposed to this, in the example of the present invention, such a steep discharge peak did not occur, and a gentle curve was drawn. That is to say, a momentary high voltage caused by the ESD is not applied between the terminals, and hence, it is understood that the sample in the example of the present invention is also useful as the ESD countermeasure element.

### Example 2

In accordance with the manufacturing methods described in the second embodiment and the third embodiment, samples of Example 2 and Example 3, in which the trigger voltage was set at 20V, were fabricated, respectively. Note that the samples were fabricated under the same manufacturing conditions as in Example 1 (refer to Table 1 in Example 1) except that the number of stacked layers in each of the element bodies was increased.

Moreover, the electrostatic capacitances, which were measured at 1 kHz, were 0.030 µF in Example 2 and 0.045 µF in Example 3 (the electrostatic capacitance in Example 1 is 0.015 µF as mentioned above).
Next, the respective samples in the Examples 2 and 3 were connected to a constant current circuit in which a maximum current was set at 300 mA, and resistance values thereof after operations were measured. Note that such a measurement was performed for 20 pieces for each of the samples, and average values were calculated.

Next, for 12 pieces for each of the samples according to the respective Examples, machine models were fabricated, and in conformity with the test standard of EIAJED-4701/304, positive and negative voltages were applied thereto five times, and a maximum voltage at which the models operated normally was measured. Then, the maximum voltage was evaluated as an ESD withstand voltage. Moreover, the ESD withstand voltage was measured also for the samples of

### Example 1.

Table 2 shows resistance values (average values) and ESD withstand voltages (average values) of the respective samples of Embodiments 1 to 3.

**[Table 2]**

| | Number of Capacitance Generation Portions | Resistance Value (Ω) | ESD Withstand Voltage (V) |
|---|---|---|---|
| Example 1 | 1 | 1.2 | 250 |
| Example 2 | 2 | 0.9 | 450 |
| Example 3 | 3 | 0.7 | 600 |

As apparent from Table 2, the resistance value can be reduced as the number of stacked layers is increased. Moreover, the electrostatic capacitance is increased as the number of stacked layers is increased, and therefore, it is confirmed that the ESD withstand voltage is also increased as the number of stacked layers is increased.

### INDUSTRIAL APPLICABILITY

In the case where the plurality of electronic components such as the LEDs are connected in series to one another, even if a part of the electronic components causes the opening failure, the anti-fuse element of the present invention can avoid an influence thereof from being given to the operations of the other electronic components. Moreover, at the time when the electronic components operate normally, the anti-fuse element also exerts the function as the ESD countermeasure element.

Moreover, the present invention can be used as the anti-fuse element, which is connected in parallel not only to the LED but also to the electronic component or the electronic instrument, is irreversibly changed from the high resistance to the low resistance by applying the overvoltage thereto, and forms the bypass circuit.

### DESCRIPTION OF REFERENCE SYMBOLS

- 4: FIRST ELECTRODE FILM (ELECTRODE FILM)
- 5: DIELECTRIC THIN FILM
- 6: SECOND ELECTRODE FILM (ELECTRODE FILM)
- 9: ELEMENT BODY
- 11: FIRST ORGANIC PROTECTION FILM (PROTECTION FILM)
- 12: SECOND ORGANIC PROTECTION FILM (PROTECTION FILM)
- 19: LED (ELECTRONIC COMPONENT)
- 20: ELEMENT BODY
- 21: FIRST ELECTRODE FILM (ELECTRODE FILM)
- 22: FIRST DIELECTRIC THIN FILM (DIELECTRIC THIN FILM)
- 23: SECOND ELECTRODE FILM (ELECTRODE FILM)
- 24: SECOND DIELECTRIC THIN FILM (DIELECTRIC THIN FILM)
- 25: THIRD ELECTRODE FILM (ELECTRODE FILM)
- 29: FIRST ORGANIC PROTECTION FILM (PROTECTION FILM)
- 30: SECOND ORGANIC PROTECTION FILM (PROTECTION FILM)
- 40: ELEMENT BODY
- 41: FIRST ELECTRODE FILM
- 42: FIRST DIELECTRIC THIN FILM
- 43: SECOND ELECTRODE FILM
- 44: SECOND DIELECTRIC THIN FILM
- 45: THIRD ELECTRODE FILM
- 46: THIRD DIELECTRIC THIN FILM
- 47: FOURTH ELECTRODE FILM
- 48: TO 51 FIRST TO FOURTH EXTRACTING ELECTRODES (EXTRACTING ELECTRODES)
- 52: INORGANIC PROTECTION FILM
- 53: FIRST ORGANIC PROTECTION FILM
- 54: SECOND ORGANIC PROTECTION FILM

## Claims

1. An anti-fuse element comprising:
an element body including a dielectric thin film and electrode films formed on both of upper and lower surfaces of the dielectric thin film,
wherein the electrode films are fused by heat generation caused when an operation voltage is applied thereto, and the electrode films are welded and electrically connected to each other.

2. The anti-fuse element according to claim 1, wherein the electrode films are fused by the heat generation caused when the operation voltage is applied thereto, and in addition, the dielectric thin film is divided, and the electrode films are welded with each other in a mode of tangling the dielectric thin film.

3. The anti-fuse element according to either one of claims 1 and 2, wherein the welded electrode films are electrified with a current of 10 mA or more.

4. The anti-fuse element according to any one of claims 1 to 3, wherein the electrode films are formed of a noble metal material.

5. The anti-fuse element according to claim 4, wherein the noble metal material contains at least one of Pt and Au.

6. The anti-fuse element according to any one of claims 1 to 5, wherein the anti-fuse element is coated with at least one or more layers of protection films made of an organic material.

7. The anti-fuse element according to any one of claims 1 to 6, wherein the element body is formed to have a stack structure including two or more capacitance generation portions, in each of which the electrode films are formed on both of upper and lower surfaces.

8. The anti-fuse element according to claim 7, wherein, among the two or more capacitance generation portions, the electrode films composing one capacitance generation portion are welded with each other preferentially to the electrode films composing other capacitance generation portion.

9. The anti-fuse element according to claim 8, wherein the dielectric thin film composing the one capacitance generation portion is formed so that a film thickness of the dielectric thin film can be thinner than a film thickness of the dielectric thin film composing the other capacitance generation portion.

10. The anti-fuse element according to claim 8, wherein insulation resistance of the dielectric thin film composing the one capacitance generation portion is lower in comparison with insulation resistance of the dielectric thin film composing the other capacitance generation portion.

11. The anti-fuse element according to claim 8, wherein the dielectric thin film composing the one capacitance generation portion is formed under a thin film forming condition where insulation resistance is lowered in comparison with insulation resistance of the dielectric thin film composing the other capacitance generation portion.

12. The anti-fuse element according to any one of claims 8 to 11, wherein a film thickness of at least one electrode film composing the one capacitance generation portion is thicker than a film thickness of at least one electrode composing the other capacitance generation portion.

13. The anti-fuse element according to any one of claims 7 to 12, wherein three or more of the capacitance generation portions are provided, and extracting electrodes that extract electric signals from the capacitance generation portions are electrically connected to the electrode films in layers different from one another.

14. The anti-fuse element according to any one of claims 9 to 13, wherein, among the electrode films of the element bodies, on a surface of an uppermost electrode film, a metal film lower in resistance than the electrode film is formed.
